# EUROPÄISCHE PATENTSCHRIFT

(11) **EP 3 411 516 B1**
(45) Veröffentlichungstag und Bekanntmachung des Hinweises auf die Patenterteilung: **13.11.2019**
(21) Anmeldenummer: 17706661.0
(22) Anmeldetag: 26.01.2017
(51) Int. Cl.: C30B 29/20, C30B 35/00

(54) **TIEGEL**
CRUCIBLE
CREUSET

(30) Priorität: 05.02.2016 AT 2216 U
(43) Veröffentlichungstag der Anmeldung: 12.12.2018
(73) Patentinhaber: Plansee SE, 6600 Reutte (AT)
(72) Erfinder: MARK, Michael, A-6600 Reutte (AT); TRAXLER, Hannes, A-6600 Reutte (AT); O'SULLIVAN, Michael, A-6600 Reutte (AT); KNABL, Wolfram, A-6600 Reutte (AT); LORICH, Alexander, A-6600 Reutte (AT); SCHIFTNER, Robert, A-6600 Reutte (AT)
(74) Vertreter: Ciesla, Bettina
(86) Internationale Anmeldenummer: PCT/AT2017/000004
(87) Internationale Veröffentlichungsnummer: WO 2017/132711

(56) Entgegenhaltungen:
- EP-A1- 2 947 054
- WO-A1-2015/002148
- CN-U- 202 011 185
- JP-A- H0 625 855
- JP-A- 2012 107 782
- SU-A1- 1 213 781

## Beschreibung

Die Erfindung betrifft einen Tiegel, insbesondere einen Tiegel zur Herstellung von Saphir-Einkristallen, mit den Merkmalen des Oberbegriffs von Anspruch 1 sowie ein Verfahren zur Herstellung eines solchen Tiegels.

Aus dem Stand der Technik ist es bekannt, zur Erschmelzung von Glas, insbesondere Quarzglas sowie bei der Zucht von Saphir-Einkristallen Tiegel aus Refraktärmetaiien zu verwenden. In der Regel kommen dabei Tiegel mit einem Grundwerkstoff aus Molybdän oder Wolfram oder deren Legierungen zum Einsatz. Unter Refraktärmetallen werden im Zusammenhang mit dieser Erfindung die Metalle der 4. Gruppe (Titan, Zirconium und Hafnium), der 5. Gruppe (Vanadium, Niob, Tantal) und der 6, Gruppe (Chrom, Molybdän, Wolfram) des Periodensystems sowie Rhenium verstanden. Diese Werkstoffe weisen unter anderem eine ausgezeichnete Formbeständigkeit bei hohen Einsatztemperaturen auf und sind gegenüber vielen Schmelzen chemisch beständig.

Als problematisch beim Einsatz von Tiegeln aus Refraktärmetallen in Hochtemperaturanwendungen (beispielsweise Ober 2000°C) hat sich die Diffusion von Sauerstoff in den Grundwerkstoff des Tiegels erwiesen. Der Sauerstoff kann beispielsweise aus einem Chargiergut stammen, mit welchem der Tiegel beschickt wurde Der in den Grundwerkstoff des Tiegels eindiffundierte Sauerstoff kann den Tiegel durch Oxidation des Grundwerkstoffes schädigen.

Häufig werden gattungsgemäße Tiegel in kohlenstoffstoffhaltigen Atmosphären eingesetzt. Der Kohlenstoff kann etwa aus Heizeinrichtungen und / oder Chargiereinrichtungen aus Graphit stammen. Der Kohlenstoff kann durch Diffusion in den Grundwerkstoff des Tiegels einwandern. Eindiffundierter Kohlenstoff führt in der Regel zur Bildung von Karbiden mit dem Grundwerkstoff und in Folge zur Versprödung desselben.

Das gemeinsame Vorhandensein von Sauerstoff und Kohlenstoff hat sich als besonders ungünstig erwiesen. Durch Rekombination des in den Tiegel eindiffundierten Sauerstoffs mit Kohlenstoff kann es zu Blasenbildung (engl. *blistering*) und Zerstörung des Tiegeis kommen.

Die Japanische Patentanmeldung JP2012107782 schlägt vor, den Grundwerkstoff des Tiegels mit einem Getter-Material für Sauerstoff auszustatten, sodass etwaiger eindiffundierter Sauerstoff vom Getter-Material gebunden wird und es so nicht zu einer unerwünschten Blasenbildung kommt. Als Getter-Materialien werden in der JP2012107782 Zirkon, Hafnium oder Tantal vorgeschlagen, die in Form fein disperser Teilchen im Grundwerkstoff des Tiegels vorliegen, Zur Herstellung des Tiegels wird in der JP2012107782 ein Verfahren vorgeschlagen, worin das den Grundwerkstoff des Tiegels bildende Metall als Pulver mit dem Getter-Material gemischt, gepresst und anschließend zum Tiegel gesintert wird. Nachteilig daran ist es, dass durch das Einbringen von Getter-Material in den Grundwerkstoff Einschränkungen hinsichtlich der Umformung und / oder Weiterverarbeitung entstehen. Zudem kann eine Verunreinigung der Schmelze durch den Getter nicht ausgeschlossen werden.

Die CN202011185U zeigt einen Tiegel aus einem Grundwerkstoff aus Molybdän, wobei an einer Außenseite der Wandung eine Schicht aus einem metallischem Werkstoff ausgewählt aus einer Eisenlegierung, einer Nickellegierung, einer Titanlegierung oder einer Kupferlegierung ausgebildet ist.

Die SU1213781 (A1) zeigt einen Tiegel mit einer Wandung (1) aus einem Grundwerkstoff aus Molybdän, wobei an einer Außenseite der Wandung eine Schicht (2) aus Wolfram ausgebildet ist.

Die JPH0625855 (A) offenbart einen Tiegel (10) mit einer Wandung (1) aus einem Grundwerkstoff aus Molybdän, wobei an einer Außenseite (14) der Wandung eine Schicht (2) aus Wolfram ausgebildet ist und offenbart ein Verfahren zur Herstellung besagten Tiegels umfassend Umformung eines Molybdänbleches zur Herstellung der Tiegelbasis und Aufbringen der Wolframschicht durch ein Spritzverfahren.

Die EP2947054 (A1) zeigt einen Tiegel, bei dem zwei Wandteile (1) aus einem Refraktärmetall oder aus einer Basislegierung eines Refraktärmetalls zusammengesetzt sind, in der Fuge ist ein Dichtmittel (5) ausgebildet. Das Dichtmittel kann Hafnium, Niob, oder Zirkonium oder aus einer Legierung mit Hafnium, Niob oder Zirkonium sein.

Aufgabe der vorliegenden Erfindung ist es, einen verbesserten Tiegel sowie ein verbessertes Verfahren zur Herstellung eines Tiegels anzugeben.

Gelöst werden diesen Aufgaben durch einen Tiegel mit den Merkmalen von Anspruch 1 sowie durch ein Verfahren mit den Merkmalen von Anspruch 8. Bevorzugte Ausführungsformen sind in den abhängigen Ansprüchen angegeben.

Der Tiegel weist eine Wandung aus Wolfram oder Molybdän oder aus einem auf Wolfram oder Molybdän basierenden Werkstoff auf. Der die Wandung bildende Werkstoff wird als Grundwerkstoff des Tiegels bezeichnet.

Als ein auf Wolfram basierender Werkstoff wird ein Werkstoff mit wenigstens 50 at.% (Atomprozent) Wolfram verstanden. Man spricht in diesem Fall auch von Wolfram-Basislegierungen. Als ein auf Molybdän basierender Werkstoff wird ein Werkstoff mit wenigstens 50 at.% (Atomprozent) Molybdän verstanden. Man spricht in diesem Fall auch von Molybdän-Basislegierungen. Als Beispiele für gängige Molybdän-Basislegierungen können ML (Molybdän-Lanthanoxid) oder MoW (Molybdän-Wolfram) genannt werden. Ein übliches Maß an Verunreinigungen beträgt beispielsweise 30 µg/g Kohlenstoff, 10 µg/g Wasserstoff, 10 µg/g Stickstoff, 40 µg/g Sauerstoff.

Indem an einer Außenseite der Wandung und / oder in der Wandung zumindest abschnittsweise eine Sperrschicht aus einem metallischen Werkstoff mit höherer Affinität gegenüber Kohlenstoff und / oder Sauerstoff als der Grundwerkstoff ausgebildet ist, wobei die Sperrschicht als eine durch Kaltgasspritzen hergestellte Schicht aus Tantal oder aus einem auf Tantal basierenden Werkstoff ausgebildet ist, wird ein Eindiffundieren von Kohlenstoff in den Grundwerkstoff des Tiegels verhindert oder reduziert und die damit verbundenen Nachteile vermieden.

Unter Affinität wird das Maß der Triebkraft einer chemischen Reaktion verstanden. Dies kann etwa durch die Freie Enthalpie (Gibbs-Energie) einer Reaktion ausgedrückt werden. Ist die Gibbs-Energie ΔG einer Reaktion positiv, läuft die Reaktion nur unter Zufuhr von Gibbs-Energie ab. Je kleiner also die Gibbs-Energie ΔG einer Reaktion, desto höher ist die Affinität der Reaktanden. Eine höhere Affinität gegenüber Kohlenstoff und / oder Sauerstoff als der Grundwerkstoff bedeutet also, dass der für die Sperrschicht vorgesehene Werkstoff eine größere Triebkraft zur Reaktion mit Kohlenstoff und / oder Sauerstoff aufweist als der Grundwerkstoff des Tiegels. Die Gibbs-Energie der Reaktion von Tantal mit Kohlenstoff zu einem Tantalkarbid ist beispielsweise kleiner als die Gibbs-Energie der Reaktion von Wolfram oder Molybdän mit Kohlenstoff zu einem Wolfram- bzw. Molybdänkarbid. Die Sperrschicht ist aus Tantal oder aus einem auf Tantal basierenden Werkstoff gebildet.

In Versuchen der Anmelderin hat sich gezeigt, dass eine erfindungsgemäße Sperrschicht wirksam ein Eindiffundieren von Kohlenstoff in den Grundwerkstoff des Tiegel verhindert. Auf diese Weise wird die eingangs beschriebene Blasenbildung durch in den Grundwerkstoff eindiffundierten Kohlenstoff zusammen mit Sauerstoff, welcher beispielsweise von einem Chargiergut oder einer Ofenatmosphäre in die Wandung übertreten kann, wirksam verhindert.

Ebenfalls durch die Sperrschicht verhindert wird die Entstehung niedrigschmelzender Phasen durch eine Karburierung (Aufkohlung) des Grundwerkstoffes, Besonders hervorzuheben ist hier das Auftreten eines Eutektikums bei Molybdän mit 17 at.% Kohlenstoff bei 2200°C. Die Sperrschicht verhindert ein Eindiffundieren von Kohlenstoff in den Grundwerkstoff des Tiegels und damit die Entstehung niedrigschmelzender Phasen.

Ebenfalls wird durch die Sperrschicht eine durch Bildung von Karbiden ausgelöste Versprödung des Grundwerkstoffs des Tiegels vermieden. Durch die hohe Affinität des die Sperrschicht bildenden Werkstoffes zu Sauerstoff bindet die Sperrschicht Sauerstoff ab, der solchermaßen nicht mehr zum eingangs erwähnten *blistering* beitragen und zudem auch nicht den Grundwerkstoff des Tiegels durch Oxidation angreifen kann.

Die Sperrschicht stellt auch einen Schutz des Chargiergutes (beispielsweise Aluminiumoxid, Al₂O₃) und in Folge des Endproduktes vor Verunreinigungen dar, welche ohne eine Sperrschicht durch die Tiegelwandung diffundieren können.

Die Wandung des Tiegels umfasst einen Mantel und einen Boden. Die Sperrschicht kann zum Beispiel nur am oder im Mantel ausgebildet sein. Sie kann aber auch am oder im Mantel und am oder im Boden ausgebildet sein. Sie kann auch nur im oder am Boden ausgebildet sein.

"Inneres" bzw. "innen" bedeutet im Kontext der Offenbarung eine Orientierung in Richtung einer vom Tiegel geildeten Kavität, Umgekehrt bedeutet "äußeres" bzw. "außen" eine dazu entgegensetzte Orientierung. Die vom Tiegel gebildete Kavität ist geeignet, ein Chargiergut aufzunehmen.

Bevorzugt ist vorgesehen, dass die Sperrschicht an einer Außenseite der Wandung des Tiegels ausgebildet ist. Mit Außenseite der Wandung ist jene Oberfläche der Wandung gemeint, welche im Einsatz des Tiegels einem Chargiergut abgewandt ist. In anderen Worten ist die Außenseite der Wandung im Einsatz einem Ofenraum zugewandt.

Im Einsatz der Tiegel liegt wegen der bevorzugten Verwendung von graphitischen Ofenkomponenten und Heizleitern häufig eine kohlenstoffhaltige Atmosphäre vor.

Anders als bei im Stand der Technik beschriebenen Maßnahmen zum Schutze eines Tiegels, nämlich Aufbringen von Schutzschichten, welche ein Reagieren und oder Verkleben eines Chargiergutes mit einer Oberfläche einer Chargiereinrichtung verhüten sollen bzw. Einbringen von Getter-Material in den Grundwerkstoff des Tiegels, welches eindiffundierten Sauerstoff abbinden soll, geht die gegenständliche Erfindung einen völlig anderen Weg:
Da die Sperrschicht aus einem metallischen Werkstoff mit höherer Affinität gegenüber Kohlenstoff als der Grundwerkstoff ausgebildet ist, bilden sich mit dem beim Einsatz des Tiegels angebotenen Kohlenstoff bevorzugt Karbide in der Sperrschicht aus.

Dies sei anhand der Sperrschicht aus Tantal näher diskutiert. Tantal bzw. Tantal-Legierungen weisen eine höhere Affinität gegenüber Kohlenstoff auf als Molybdän, Wolfram oder Legierungen daraus. Dies zeigt zum Beispiel der Vergleich der Reaktionsenthalpien von Kohlenstoff mit Tantal, Molybdän bzw. mit Wolfram, siehe dazu etwa E. Fromm und E. Gebhardt (Hrsg.): Gase und Kohlenstoff in Metallen, Springer Verlag, Berlin-Heidelberg-New York 1976.

Im Einsatz des erfindungsgemäßen Tiegels mit einer Sperrschicht aus Tantal in einer Kohlenstoff-haltigen Ofenatmosphäre kommt es also zur Bildung von Tantal-Karbid in der Sperrschicht. Abhängig von der Menge des angebotenen Kohlenstoffs bzw. der Einsatzdauer des Tiegels reagiert die komplette Sperrschicht zu Tantal-Karbid. Die sich bildenden Phasen sind TaC_{0,5} (in anderer Schreibweise auch als Ta₂C bezeichnet) und bei genügend Angebot an Kohlenstoff schließlich TaC.

Der Wirkmechanismus der Sperrschicht, durch welchen eine Diffusion von Kohlenstoff in den Grundwerkstoff des Formkörpers verhindert wird, ist also zunächst ein Aufzehren des eindiffundierenden Kohlenstoffs unter Bildung von Tantal-Karbid in der Sperrschicht. Wird über die Einsatzdauer des Tiegels darüber hinaus Kohlenstoff angeboten, ist die Diffusionsgeschwindigkeit des Kohlenstoffs durch die ausgebildete Karbidschicht signifikant herabgesetzt und eine weitere Diffusion von Kohlenstoff in den Grundwerkstoff des Tiegels wirksam hintangestellt. Die Diffusionsgeschwindigkeit von Kohlenstoff in TaC_{0,5} bzw. TaC ist um vieles geringer als die Diffusionsgeschwindigkeit von Kohlenstoff in Molybdän, wie die folgende Tabelle zeigt:

| **Matrix** | **Element** | **D (cm²/s) bei 2100°C** |
|---|---|---|
| Mo | C | (6 - 9) x 10⁻⁶ |
| TaC_{0,5} | C | 4 x 10⁻⁸ |
| TaC | C | 7 x 10⁻⁹ |

In der ersten Spalte "Matrix" ist die Matrix angegeben, in welchem das in der zweiten Spalte "Element" genannte Element diffundiert. Die dritte Spalte "D (cm²/s) bei 2100°C" nennt den Diffusionskoeffizienten in cm²/s des Elements in der jeweiligen Matrix bei einer Temperatur von 2100°C. Die Werte sind Handbüchern zur Diffusion in Metallen entnommen, siehe zum Beispiel E. Fromm und E. Gebhardt (Hrsg.): Gase und Kohlenstoff in Metallen, Springer Verlag, Berlin-Heidelberg-New York 1976, Smithells Metals Reference Book, Editors E.A. Brandes and G.B. Brook, 7th Edition (1992) sowie Diffusion Data, Vol. 1, No.1 (1967).

Aus dem Vergleich der Diftusionskoeffizienten von Kohlenstoff in Molybdän, TaC_{0,5} bzw. TaC ist ersichtlich, dass die Diffusionsgeschwindigkeit von Kohlenstoff in den Tantalkarbiden TaC_{0.5} bzw. TaC um Größenordnungen geringer ist als in Molybdän.

Dies macht deutlich, dass die Sperrschicht eine wirkungsvolle Diffusionsbarriere für Kohlenstoff darstellt. Am obigen Beispiel für Tantal diskutiert, wirkt in analoger Weise auch eine Sperrschicht aus anderen metallischen Werkstoffen mit einer höheren Affinität gegenüber Kohlenstoff als der Grundwerkstoff. Zur Auswahl alternativer geeigneter Werkstoffe für die Sperrschicht sei auf die genannte Literatur bzw. einschlägige Tabellenwerke verwiesen.

Unter Sperrschicht wird im Zusammenhang mit der vorliegenden Erfindung eine kontinulerliche und im Wesentlichen dichte Schicht verstanden.

Die Sperrschicht kann dabei direkt an einer Außenseite der Wandung des Tiegels ausgebildet sein.

Ebenfalls verstellbar ist es, dass die Sperrschicht in einer Wandung des Tiegels ausgebildet ist.

Es kann vorgesehen sein, dass die Sperrschicht von einer Deckschicht aus einem von der Sperrschicht verschiedenen Material, vorzugsweise aus dem den Tiegel bildenden Grundwerkstoff, bedeckt ist, vorzugsweise vollständig bedeckt ist.

Diese Variante lässt sich beispielsweise dadurch erzielen, dass auf die Sperrschicht eine weitere Schicht, die Deckschicht, aufgebracht wird, wobei die Deckschicht vorzugsweise aus jenem Material gebildet ist, welches auch den Grundwerkstoff des Tiegels bildet. Im Falle eines Tiegels aus Molybdän heißt das also, dass auf die Sperrschicht eine Deckschicht aus Molybdän aufgetragen ist. In dieser Variante ist die Sperrschicht durch die zusätzliche Schicht, die Deckschicht, aus Molybdän geschützt. Dies hat sich als besonders vorteilhaft erwiesen, um die Sperrschicht vor Oxidation - beispielsweise durch Abbauprodukte eines im Tiegel erschmolzenen Aluminiumoxids - zu schützen. Eine solche Deckschicht ist auch besonders dann vorteilhaft, wenn der Tiegel, umfassend die Sperrschicht, bei Bedingungen eingesetzt werden soll, unter welchen die Sperrschicht nicht beständig ist. Ein Beispiel dafür ist eine Wasserstoff-Atmosphäre für eine Sperrschicht aus Tantal bzw. aus einer Tantallegierung. Die Deckschicht dient auch zum Schutz des Chargiergutes vor möglichen Verunreinigungen aus der Sperrschicht.

Es kann vorgesehen sein, die Deckschicht aus einem anderen Werkstoff herzustellen, der die Sperrschicht vor Oxidation schützt. Denkbar ist etwa eine durch thermisches Spritzen aufgebrachte keramische Schicht, beispielsweise aus Aluminiumoxidschicht.

Auch kann es vorgesehen sein, dass eine Sperrschicht sowohl an der Wandung als auch eine Sperrschicht in der Wandung ausgebildet ist. Diese Variante beschreibt den Fall, gemäß welchem eine Wandung des Tiegels äußerlich mit einer Sperrschicht versehen ist und auch innerhalb der Wandung des Tiegels eine Sperrschicht ausgebildet ist. Auf diese Weise kann eine besonders hohe Sperrwirkung gegen Diffusion von Kohlenstoff erzielt werden. In anderen Worten besteht die Wandung des Tiegels in diesem Fall aus einem Schichtverbund.

Die Deckschickt bedeckt die Sperrschicht vorzugsweise vollständig. Es ist aber auch vorstellbar, dass die Deckschicht nur Teilbereiche der Sperrschicht bedeckt.

Bevorzugt ist vorgesehen, dass die Sperrschicht in einem äußeren Drittel der Wandung ausgebildet ist. In anderen Worten bedeutet dies, dass die Sperrschicht in jenem Drittel einer Wandstärke des Tiegels angeordnet ist, welches unter Einsatzbedingungen des Tiegels einer Ofenatmosphäre zugewandt ist. Damit kommt zum Ausdruck, dass die Sperrschicht, bezogen auf einen Querschnitt der Wandung des Tiegels bevorzugt außen liegt.

Damit wird erreicht, dass etwaiger eindiffundierender Kohlenstoff bereits in einem - bezogen auf den Querschnitt des Tiegels - äußeren Bereich abgebunden bzw. eine Diffusion in weiter innen gelegene Bereiche des Tiegels verhindert wird.

Besonders vorteilhaft ist es, wenn die Sperrschicht als eine im Wesentlichen dichte Schicht ausgebildet ist. Dieser Aspekt ist günstig hinsichtlich einer durchgängigen Sperre gegenüber einer Diffusion von Kohlenstoff in den Grundwerkstoff des Tiegels. Würde die Sperrschicht Lücken oder beträchtliche Porosität aufweisen, wäre eine wirkungsvolle Sperre gegenüber Diffusion von Kohlenstoff nicht gegeben.

Günstigerweise weist die Schicht eine relative Dichte von über 90%, bevorzugt über 95%, besonders bevorzugt über 99% auf. Die relative Dichte ist das Komplement zur Porosität, d.h. eine relative Dichte von 95% entspricht einer Porosität der Sperrschicht von 5%. Die relative Dichte kann etwa durch quantitative Gefügeanalyse an einem Querschliff der Sperrschicht bestimmt werden.

Bevorzugt ist vorgesehen, dass die Sperrschicht eine Stärke zwischen 25 µm und 500 µm, bevorzugt zwischen 100 µm und 300 µm, besonders bevorzugt eine Stärke zwischen 175 µm und 225 µm aufweist. Diese Schichtstärken haben sich in Versuchen als wirksam und wirtschaftlich erwiesen.

Erfindungsgemäß ist die Sperrschicht als eine durch Kaltgasspritzen hergestellte Schicht ausgebildet. Bei dem an sich bekannten Kaltgasspritzen (auch CGS von engl. *cold gas spraying* genannt) werden Pulverpartikel mit sehr hoher kinetischer und geringer thermischer Energie auf ein Trägermaterial aufgebracht. Die Pulverpartikel werden in einer Düse von einem Prozessgas auf Geschwindigkeiten von typischerweise 300 bis 1.200 m/s beschleunigt und auf einem Substrat abgeschieden.

Der Fachmann kann eine über Kaltgasspritzen hergestellte Schicht ohne weiteres von alternativ hergestellten Schichten unterscheiden. Die Körner der entstehenden Schicht sind zumindest bereichsweise kaltverformt und zeichnen sich durch eine im Vergleich zu thermischen Spritzverfahren vergleichsweise hohe Härte aus. Eine über Kaltgasspritzen hergestellte Schicht weist eine hohe relative Dichte im Sinne einer geringen Porosität auf. Auch wird beim Kaltgasspritzen der Beschichtungsstoff nicht aufgeschmolzen und es findet keine prozessbedingte Oxidation statt.

Bevorzugt ist vorgesehen, dass die Sperrschicht einen Gehalt von wenigstens 90 Gewichts-Prozent (gew. %) des metallischen Werkstoff mit höherer Affinität gegenüber Kohlenstoff und / oder Sauerstoff als der Grundwerkstoff aufweist.

Besonders bevorzugt ist die Verwendung des Tiegels als Tiegel zur Herstellung von Saphir-Einkristallen oder Quarzglas. Bei der Herstellung von Saphir-Einkristallen wird meist ein Tiegel mit Aluminiumoxid (Al₂O₃) beschickt und das Aluminiumoxid im Tiegel in einem Ofen bis zu seiner Schmelztemperatur von rund 2050°C erwärmt. Die weiteren Verfahrensschritte unterscheiden sich darin, wie aus dem erschmolzenen Aluminiumoxid der Saphirkristall gezogen und entnommen wird. Gängige Verfahren sind beispielsweise der Kyropoulos-Prozess, der HEM-Prozess (engl. *Heat Exchanger Method*) oder das EFG-Verfahren (engl. *edge-defined film-fed growth*).

Das Verfahren zur Herstellung des erfindungsgemäßen Tiegels umfasst die Schritte:
- Bereitstellen eines Rohlings durch Pressen und Sintern von Pulver von Refraktärmetall, bevorzugt Molybdän oder Wolfram oder Pulvermischungen davon und / oder durch Umformung,
- Aufbringen einer Sperrschicht aus einem metallischen Werkstoff mit höherer Affinität gegenüber Kohlenstoff und / oder Sauerstoff als der Grundwerkstoff durch thermisches Spritzen, insbesondere durch Kaltgasspritzen, oder ein Slurry-Verfahren auf eine Außenseite des Rohlings

Optional kann vor dem Schritt des Aufbringens der Sperrschicht noch ein Strahlen der zu beschichtenden Oberflächen des Rohlings vorgesehen sein. Durch Strahlen, beispielsweise Sandstrahlen, wird die Oberfläche des Rohlings so aufbereitet, dass die nachfolgend aufgetragene Schicht besser haftet.

Unter Rohling wird im Kontext der vorliegenden Anmeldung der Tiegel vor dem Auftrag der Sperrschicht verstanden. Wie der Tiegel weist der Rohling daher wenigstens eine Wandung auf. Die für den Tiegel erläuterten geometrischen Beziehungen gelten gleichermaßen für den Rohling.

Der Rohling wird beispielsweise durch Pressen und Sintern eines Pulvers von Refraktärmetall, insbesondere Wolfram oder Molybdän oder Pulvermischung davon hergestellt. Das Pulver von Refraktärmetall kann zum Beispiel reines Molybdän-Pulver oder reines Wolfram-Pulver sein.

Es können aber auch Refraktärmetalllegierungen als Pulver verwendet werden. Ebenfalls ist es möglich, Pulvermischungen von Refraktärmetallen oder deren Legierungen einzusetzen.

Der Herstellungsweg über Pressen und Sintern eines Pulvers wird üblicherweise als "p/s" für engl. *pressed-sintered* bezeichnet.

Alternativ kann der Rohling über eine Umformung erhalten werden. Dazu wird beispielsweise ein Blech tiefgezogen oder gedrückt. Eine weitere Möglichkeit ist die Herstellung des Rohlings über Falten von Blech.

Auch kann ein Rohling erhalten werden, indem zunächst eine Mantelfläche in Form einer Zylinderhülse hergestellt wird und diese mit einem Bodenabschnitt verbunden wird, sodass eine Tasse erhalten wird. Dazu wird beispielsweise die Zylinderhülse in eine zentrale Öffnung in einen Tassenboden eingesteckt und durch eine Körnung verbunden. Durch das Körnen werden Hülse und Tassenboden verformt, so dass eine nietartige Verbindung hergestellt wird.

Ebenso vorstellbar ist es, einen p/s Rohling einem formgebenden Umformschritt zu unterziehen.

In weiterer Folge wird die Sperrschicht aus dem metallischen Werkstoff mit höherer Affinität gegenüber Kohlenstoff und / oder Sauerstoff als der Grundwerkstoff durch Kaltgasspritzen an der Außenseite der Wandung des Rohlings aufgebracht.

Alternativen zum Kaltgasspritzen sind beispielsweise Vakuum-Plasma-Spritzen (VPS) oder eine physikalische Dampfabscheidung (PVD). Wegen der im Vergleich zum Kaltgasspritzen geringeren Ausbeute eines VPS-Verfahrens und des langsamen Schichtaufbaus in einem PVD-Verfahren sind diese Alternativen jedoch meist weniger wirtschaftlich als das Kaltgasspritzen. Unter Ausbeute versteht man den Anteil des tatsächlich zum Schichtaufbau beitragenden Materials zum eingesetzten Material.

Nicht erfindungsgemäß sind Slurry-Verfahren zum Aufbringen der Sperrschicht. Dabei wird ein pulverförmiger Beschichtungswerkstoff - etwa Tantal - mit einem organischen Binder zu einem Schlicker (engl. *slurry)* verarbeitet und auf die zu beschichtenden Oberfläche aufgetragen. Dieses Verfahren erfordert eine Wärmebehandlung zum Austreiben des Binders und Festigen der Pulverschicht.

Es kann vorgesehen sein, dass auf die Sperrschicht aus dem metallischen Werkstoff mit höherer Affinität gegenüber Kohlenstoff und / oder Sauerstoff als der Grundwerkstoff eine weitere Schicht aus einem weiteren Werkstoff, vorzugsweise aus dem den Grundwerkstoff des Tiegels bildenden Werkstoff aufgebracht wird. Das erfinderische Verfahren soll anhand eines Herstellungsbeispiels näher erläutert werden:
Für den Tiegel wurde ein Rohling aus Molybdän über Pressen und Sintern von Molybdänpulver hergestellt. Wie bereits erläutert, erfolgt bei der Herstellungsroute über Pressen und Sintern die Formgebung am Pulver.

Die äußere Mantelfläche des Rohlings wurde über Kaltgasspritzen mit Tantal beschichtet. Als Beschichtungsstoff wurde kommerziell verfügbares Tantal-Pulver verwendet (Amperit 151.065 der H.C. Starck GmbH, Laufenburg).

Folgende Beschichtungsparameter kamen zur Anwendung:
- Prozessgas: Stickstoff
- Prozessgasdruck: 38 bar
- Förderrate Ta-Pulver: 46 g/min
- Prozessgastemperatur: 800°C
- Abstand Beschichtungspistole - Grundkörper: 40 mm

Die Beschichtung erfolgte in überlappenden Bahnen und wurde solange durchgeführt, bis eine Schichtstärke von rund 280 µm erreicht wurde.

Die erhaltene Sperrschicht wies eine relative Dichte von rund 99,5% auf, oder anders ausgedrückt einen Porenanteil von 0,05% auf. Die Bestimmung des Porenanteils erfolgte durch Flächenanalyse aus einer rastermikroskopischen Aufnahme der Sperrschicht im Querschliff.

In Versuchen wurde an der beschichteten Seite des Tiegels Kohlenstoff angeboten und der Tiegel bei 2100°C 6 Stunden geglüht. Eine danach durchgeführte metallographische Untersuchung zeigte keine Bildung von Karbiden im Grundwerkstoff Molybdän. Bei unbeschichteten Referenzproben hingegen wurde eine nennenswerte Karbidbildung im Grundwerkstoff Molybdän festgestellt. Die Sperrschicht aus Tantal verhindert also wirkungsvoll die Eindiffusion von Kohlenstoff in den Grundwerkstoff des Tiegels und die damit verbundenen negativen Effekte.

In einem weiteren Herstellungsbeispiel wurde auf die Sperrschicht aus Tantal eine zusätzliche, 50 µm starke Schicht aus Molybdän über ein Atmosphären-Plasma-Spray (APS) Verfahren aufgebracht. Erfindungsgemäß erfolgt der Auftrag über CGS.

Erfindungsgemäß ist die Sperrschicht aus Tantal oder aus einem auf Tantal basierenden Werkstoff gebildet, da Tantal besonders ausgewogene Eigenschaften hinsichtlich der Sperrwirkung sowie Beständigkeit zeigt.

Die Erfindung wird im Folgenden anhand der Figuren näher erläutert.

Dabei zeigen:
- Fig. 1: einen Tiegel mit einer Schutzschicht (Stand der Technik)
- Fig. 2: einen Tiegel mit dispers im Grundwerkstoff eingebettetem Getterwerkstoff (Stand der Technik)
- Fig. 3a und 3b: je einen Tiegel der Erfindung
- Fig. 4: einen Tiegel der Erfindung in einem weiteren Ausführungsbeispiel
- Fig. 5: eine lichtmikroskopische Aufnahme einer erfindungsgemäßen Sperrschicht im Querschliff
- Fig. 6: eine lichtmikroskopische Aufnahme einer erfindungsgemäßen Sperrschicht mit zusätzlicher Deckschicht im Querschliff
- Fig. 7: ein Schema des Verfahrens zur Herstellung eines erfindungsgemäßen Tiegels

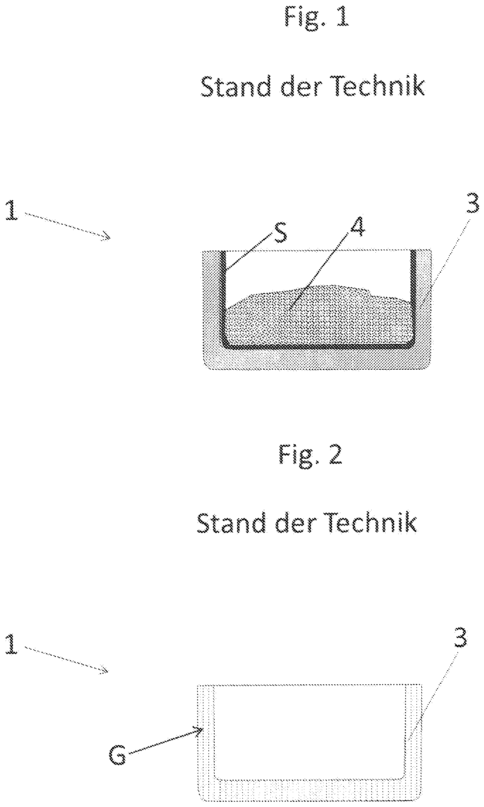

Figur 1 zeigt einen Tiegel nach Stand der Technik mit einer Schutzschicht S auf der Innenseite der Wandung 3 des Tiegels 1. Die Schutzschicht S verhindert eine Reaktion und / oder ein Verkleben eines Chargiergutes 4 mit dem Tiegel 1. Eine Wandung 3 des Tiegels 1 besteht beispielsweise aus Molybdän. Die Schutzschicht S besteht beispielsweise aus Wolfram.

Figur 2 zeigt einen Tiegel 1 nach Stand der Technik mit einem dispers im Grundwerkstoff des Tiegels 1 eingebetteten Getterwerkstoff G, schematisch als Punkte dargestellt. Als Getterwerkstoff G kommen Sauerstoff-affine Elemente wie Zirkon, Hafnium oder Tantal in Betracht. Der Getterwerkstoff G kann in den Grundwerkstoff des Tiegels 1 eindiffundierende Elemente wie Sauerstoff und / oder Kohlenstoff abbinden.

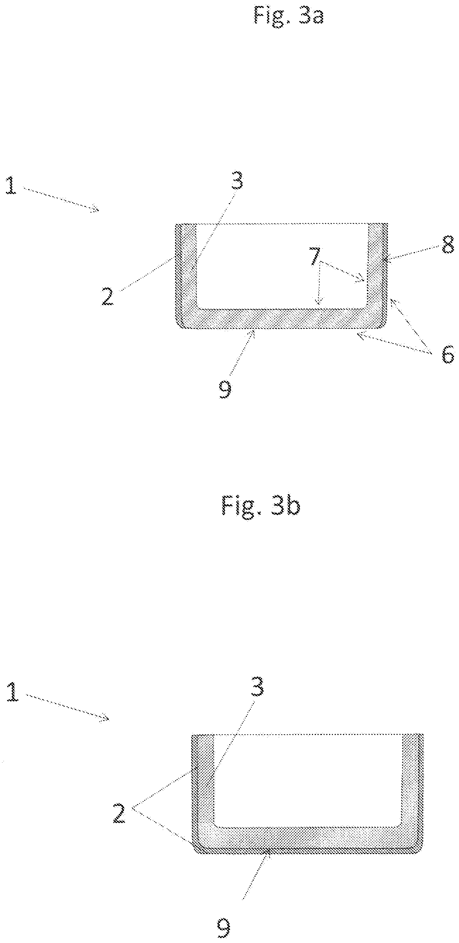

Figur 3a zeigt einen Tiegel 1 gemäß der Erfindung in einem ersten Ausführungsbeispiel.

Zur Festlegung der Orientierungen sind anhand Figur 3a die Außenseite 6 sowie die Innenseite 7 des Tiegels 1 bezeichnet. Der Tiegel 1 weist eine Mantelfläche 8 und einen Boden 9 auf. Im vorliegenden Ausführungsbeispiel ist die Mantelfläche 8 eine Zylinderfläche und der Boden 9 eine Kreisfläche. Der Tiegel 1 kann aber auch eine von der Zylinderform abweichende Gestalt aufweisen.

Eine Sperrschicht 2 ist als kontinuierliche und dichte Schicht an der Außenseite der Wandung 3 ausgebildet, Die Sperrschicht 2 ist in dem vorliegenden Ausführungsbeispiel als kaltgasgespritzte Schicht aus Tantal ausgeführt. Im vorliegenden Ausführungsbeispiel gemäß Figur 3a ist die Sperrschicht 2 lediglich an der Mantelfläche 8 des Tiegels 1 ausgeführt.

Ebenso möglich ist es, die Sperrschicht 2 zusätzlich auch an der Außenseite des Bodens 9 auszuführen, wie in Figur 3b dargestellt.

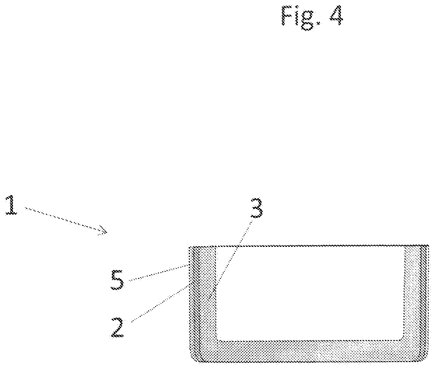

Figur 4 zeigt einen Tiegel 1 der Erfindung in einem weiteren Ausführungsbeispiel.

Die Sperrschicht 2 ist wie im Ausführungsbeispiel gemäß Figur 3a ausgeführt. Im vorliegenden Ausführungsbeispiel ist die Sperrschicht 2 jedoch noch von einer zweiten Schicht, der Deckschicht 5, umgeben, die vorzugsweise aus dem den Grundwerkstoff des Tiegels 1 bildenden Werkstoff besteht. Im Falle eines Tiegels 1 aus Molybdän ist also die Deckschicht 5 aus Molybdän gebildet. Die Deckschicht 5 ist besonders dann vorteilhaft, wenn der Tiegel 1, umfassend die Sperrschicht 2, bei Bedingungen eingesetzt werden soll, unter welchen die Sperrschicht 2 nicht beständig ist. Ein Beispiel dafür ist eine Wasserstoff-Atmosphäre für eine Sperrschicht 2 aus Tantal bzw. aus einer Tantallegierung.

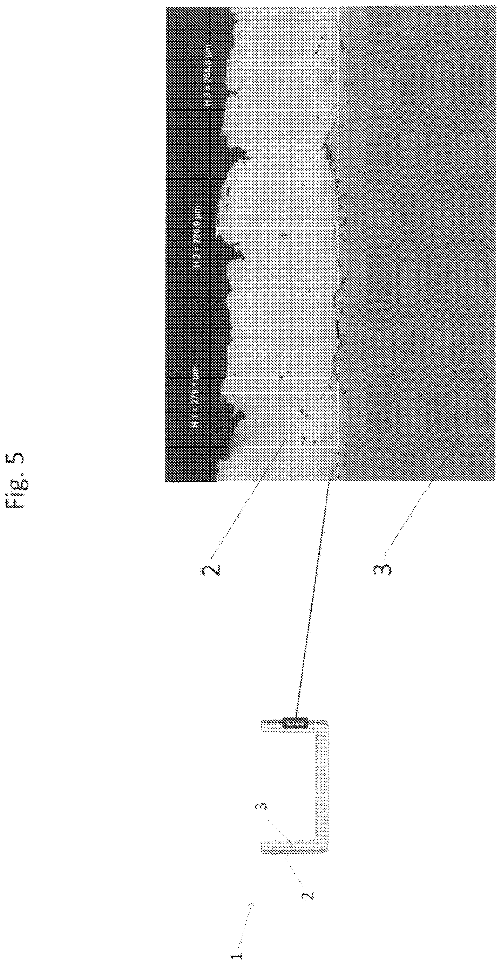

Figur 5 zeigt eine lichtmikroskopische Aufnahme einer Sperrschicht 2 in einem Querschliff eines Abschnittes der Wandung 3 eines erfindungsgemäßen Tiegels 1 in einem Ausführungsbeispiel. Zur Orientierung ist die Lage der Aufnahme in der Wandung 3 illustriert.

Die Sperrschicht 2 ist durch Kaltgasspritzen auf der Wandung 3 des Tiegels 1 aufgetragen. Zwischen der Sperrschicht 2 und der Wandung 3 sind sogenannte Kirkendall-Poren zu erkennen, welche durch eine Glühung des Tiegels 1 entstanden sind. Die Schichtstärke der Sperrschicht 2 liegt im vorliegenden Beispiel bei ca. 280 µm.

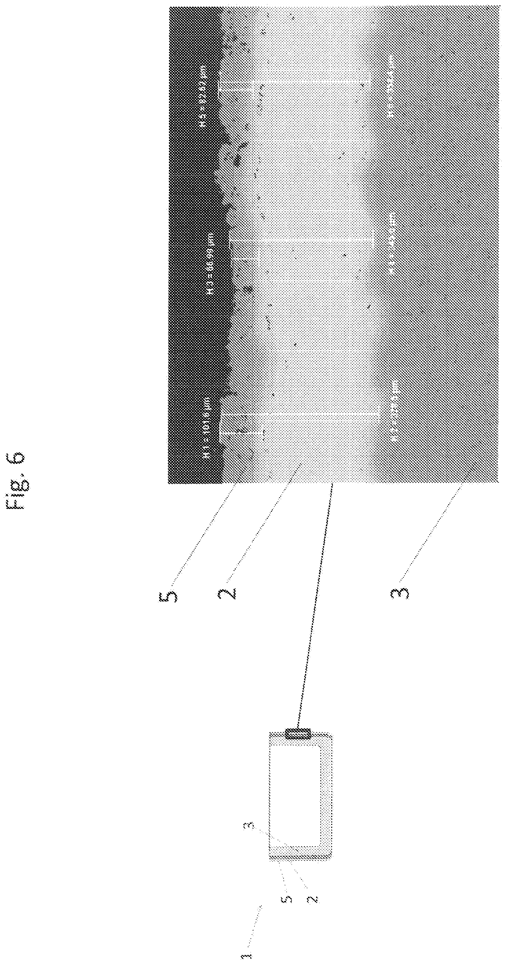

Figur 6 zeigt eine lichtmikroskopische Aufnahme eines weiteren Ausführungsbeispiels einer Sperrschicht 2 im Querschliff eines Wandungsabschnittes eines erfindungsgemäßen Tiegels 1 in einem weiteren Ausführungsbeispiel. Zur Orientierung ist die Lage der Aufnahme in der Wandung 3 illustriert. Die Sperrschicht 2 ist durch Kaltgasspritzen auf der Wandung 3 des Tiegels 1 aufgetragen. Auf die Sperrschicht 2 ist eine weitere Schicht, die Deckschicht 5, aufgetragen. Im vorliegenden Beispiel handelt es sich bei der Deckschicht 5 um eine - durch APS aufgetragene - Schicht aus Molybdän.

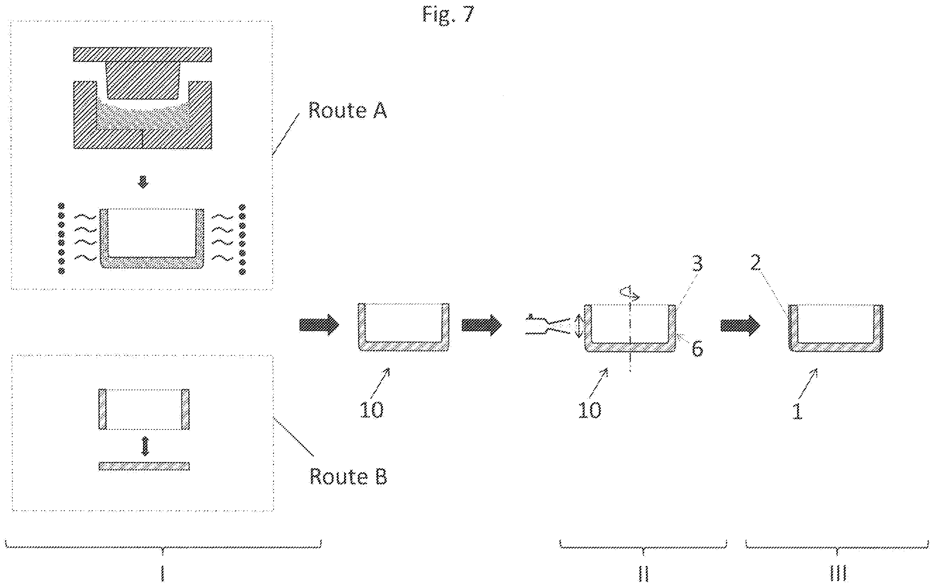

Figur 7 zeigt schematisch das Verfahren zur Herstellung eines erfindungsgemäßen Tiegels 1.

### Schritt I:

Bereitstellen eines Rohlings 10 durch Pressen und Sintern von Pulver von Refraktärmetall, bevorzugt Molybdän oder Wolfram oder Pulvermischungen davon und / oder durch Umformung.

In der linken Bildhälfte werden zwei alternative Routen zur Darstellung eines Rohlings 10 dargestellt. Gemäß Route A wird der Rohling 10 über Pressen und Sintern von Ausgangspulver aus Mo, W oder Pulvergemischen davon oder legierten Pulvern hergestellt.

Gemäß Route B erfolgt die Herstellung des Rohlings 10 über Verbindung einer Mantelfläche 8 und eines Bodens 9, welche zuvor über Umformung erzeugt wurden. Alternativ könnte der Rohling 10 auch über Tiefziehen oder Drücken hergestellt werden.

### Schritt II:

In weiterer Folge wird an einer Außenseite 6 der Wandung 3 des Rohlings 10 eine Sperrschicht 2 aus einem metallischen Werkstoff mit höherer Affinität gegenüber Kohlenstoff und / oder Sauerstoff als der Grundwerkstoffdurch durch Kaltgasspritzen aufgebracht. Beispiele für die Sperrschicht geeignete Werkstoffe sind Tantal oder Legierungen daraus.

### Schritt III:

Man erhält einen erfindungsgemäßen Tiegel 1 mit einer Sperrschicht 2.

### Liste der verwendeten Bezugszeichen:

- 1: Tiegel
- 2: Sperrschicht
- 3: Wandung
- 4: Chargiergut
- 5: Deckschicht
- 6: Außenseite des Tiegels
- 7: Innenseite des Tiegels
- 8: Mantelfläche des Tiegel
- 9: Boden des Tiegels
- 10: Rohling
- G: Getterwerkstoff
- S: Schutzschicht

## Patentansprüche

1. Tiegel (1) mit einer Wandung (3) aus einem Grundwerkstoff aus Wolfram oder Molybdän oder aus einem auf Wolfram oder Molybdän basierenden Werkstoff, wobei an einer Außenseite (6) der Wandung (3)
und / oder in der Wandung (3) zumindest abschnittsweise eine Sperrschicht (2) aus einem metallischen Werkstoff mit höherer Affinität gegenüber Kohlenstoff und / oder Sauerstoff als der Grundwerkstoff ausgebildet ist, **dadurch gekennzeichnet, dass** die Sperrschicht (2) als eine durch Kaltgasspritzen hergestellte Schicht aus Tantal oder aus einem auf Tantal basierenden Werkstoff ausgebildet ist.

2. Tiegel (1) nach Anspruch 1, wobei die Sperrschicht (2) von einer Deckschicht (5) aus einem von der Sperrschicht (2) verschiedenen Material, vorzugsweise aus dem den Tiegel (1) bildenden Grundwerkstoff, bedeckt ist, vorzugsweise vollständig bedeckt ist.

3. Tiegel (1) nach wenigstens einem der vorangegangenen Ansprüche, wobei die Sperrschicht (2) in einem äußeren Drittel der Wandung (3) ausgebildet ist.

4. Tiegel (1) nach wenigstens einem der vorangegangenen Ansprüche, wobei die Sperrschicht (2) als eine im Wesentlichen dichte Schicht ausgebildet ist.

5. Tiegel (1) nach wenigstens einem der vorangegangenen Ansprüche, wobei die Sperrschicht (2) eine relative Dichte von über 90%, bevorzugt über 95%, besonders bevorzugt über 99% aufweist.

6. Tiegel (1) nach wenigstens einem der vorangegangenen Ansprüche, wobei die Sperrschicht (2) eine Stärke zwischen 25 µm und 500 µm, bevorzugt zwischen 100 µm und 300 µm, besonders bevorzugt eine Stärke zwischen 175 µm und 225 µm aufweist.

7. Verwendung eines Tiegels (1) nach wenigstens einem der vorangegangenen Ansprüche als Tiegel zur Herstellung von Saphir-Einkristallen oder Quarzglas.

8. Verfahren zur Herstellung eines Tiegels (1) für Hochtemperaturanwendungen, umfassend die Schritte:
- Bereitstellen eines Rohlings (10) aus einem Grundwerkstoff aus Refraktärmetall durch Pressen und Sintern von Pulver von Refraktärmetall, bevorzugt Molybdän oder Wolfram und deren Legierungen oder Pulvermischungen davon und / oder durch Umformung,
- Aufbringen einer Sperrschicht (2) aus einem metallischen Werkstoff mit höherer Affinität gegenüber Kohlenstoff und / oder Sauerstoff als der Grundwerkstoff durch Kaltgasspritzen auf eine Außenseite (6) des Rohlings (10), wobei für die Sperrschicht (2) Tantal oder ein auf Tantal basierender Werkstoff verwendet wird.

9. Verfahren nach Anspruch 8, wobei auf die Sperrschicht (2) eine Deckschicht (5) aus einem weiteren Werkstoff, vorzugsweise aus dem den Grundwerkstoff des Tiegels (1) bildenden Werkstoff aufgebracht wird.

## Claims

1. A crucible (1) having a wall (3) made of a base material of tungsten or molybdenum or of a material based on tungsten or molybdenum, wherein on an outer side (6) of the wall (3) and/or in the wall (3), at least in sections, a barrier layer (2) is configured which is made of a metallic material having greater affinity for carbon and/or oxygen than the base material, **characterized in that** the barrier layer (2) is configured as a layer produced by cold gas spraying of tantalum or of a material based on tantalum.

2. The crucible (1) as claimed in claim 1, wherein the barrier layer (2) is covered, preferably completely covered, by an outer layer (5) made of a material different than the barrier layer (2), preferably of the base material which forms the crucible (1).

3. The crucible (1) as claimed in at least one of the preceding claims, wherein the barrier layer (2) is configured in an outer third of the wall (3).

4. The crucible (1) as claimed in at least one of the preceding claims, wherein the barrier layer (2) is configured as a substantially dense layer.

5. The crucible (1) as claimed in at least one of the preceding claims, wherein the barrier layer (2) has a relative density of more than 90%, preferably more than 95%, more preferably more than 99%.

6. The crucible (1) as claimed in at least one of the preceding claims, wherein the barrier layer (2) has a thickness of between 25 µm and 500 µm, preferably between 100 µm and 300 µm, more preferably a thickness of between 175 µm and 225 µm.

7. The use of a crucible (1) as claimed in at least one of the preceding claims as a crucible for producing single-crystal sapphire or fused quartz.

8. A method for producing a crucible (1) for high-temperature applications, comprising the steps of:
- providing a blank (10) made of a base material of refractory metal by pressing and sintering refractory metal powder, preferably molybdenum or tungsten and alloys thereof or powder mixtures of these, and/or by forming,
- applying a barrier layer (2) made of a metallic material having greater affinity for carbon and/or oxygen than the base material by cold gas spraying to an outer side (6) of the blank (10), wherein tantalum or a material based on tantalum is used for the material which forms the barrier layer (2).

9. The method as claimed in claim 8, wherein an outer layer (5) made of a further material, preferably of the material which forms the base material of the crucible (1), is applied to the barrier layer (2).

## Revendications

1. Creuset (1) avec une paroi (3) en un matériau de base en tungstène ou en molybdène ou en un matériau à base de tungstène ou de molybdène, dans lequel une couche de barrage (2) en un matériau métallique avec une plus forte affinité pour le carbone et/ou l'oxygène que le matériau de base est formée au moins partiellement sur un côté extérieur (6) de la paroi (3) et/ou dans la paroi (3), **caractérisé en ce que** la couche de barrage (2) est réalisée sous la forme d'une couche en tantale ou en un matériau à base de tantale produite par projection au gaz à froid.

2. Creuset (1) selon la revendication 1, dans lequel la couche de barrage (2) est recouverte, de préférence recouverte entièrement, par une couche de couverture (5) en un matériau différent de celui de la couche de barrage (2), de préférence constituée du matériau de base formant le creuset (1).

3. Creuset (1) selon au moins une des revendications précédentes, dans lequel la couche de barrage (2) est formée dans un tiers extérieur de la paroi (3).

4. Creuset (1) selon au moins une des revendications précédentes, dans lequel la couche de barrage (2) est réalisée sous la forme d'une couche essentiellement dense.

5. Creuset (1) selon au moins une des revendications précédentes, dans lequel la couche de barrage (2) présente une densité relative de plus de 90 %, de préférence de plus de 95 %, de préférence encore de plus de 99 %.

6. Creuset (1) selon au moins une des revendications précédentes, dans lequel la couche de barrage (2) présente une épaisseur comprise entre 25 µm et 500 µm, de préférence entre 100 µm et 300 µm, de préférence encore une épaisseur comprise entre 175 µm et 225 µm.

7. Utilisation d'un creuset (1) selon au moins une des revendications précédentes comme creuset pour la fabrication de monocristaux de saphir ou de verre de quartz.

8. Procédé de fabrication d'un creuset (1) pour des applications à haute température, comprenant les étapes suivantes:
- préparer une ébauche (10) en un matériau de base en métal réfractaire par compactage et frittage de poudre de métal réfractaire, de préférence de molybdène ou de tungstène et de leurs alliages ou de mélanges de poudres de ceux-ci et/ou par formage,
- appliquer une couche de barrage (2) en un matériau métallique avec une plus forte affinité pour le carbone et/ou l'oxygène que le matériau de base par projection au gaz à froid sur un côté extérieur (6) de l'ébauche (10), dans lequel on utilise pour la couche de barrage (2) du tantale ou un matériau à base de tantale.

9. Procédé selon la revendication 8, dans lequel on dépose sur la couche de barrage (2) une couche de couverture (5) en un autre matériau, de préférence en matériau formant le matériau de base du creuset (1).
